# EUROPEAN PATENT APPLICATION

(11) **EP 4 597 138 A1**
(43) Date of publication of application: **06.08.2025**
(21) Application number: 25150058.3
(22) Date of filing: 02.01.2025
(51) Int. Cl.: G01R 31/42, H02P 29/024, G01R 31/34

(54) **POWER ELECTRONICS MODULE CONDITION MONITORING**

(30) Priority: 25.01.2024 GB 202400989
(71) Applicant: Rolls-Royce plc, London N1 9FX (GB)
(72) Inventor: Nadarajan, Sivakumar, Derby, DE24 8BJ (GB); Vaiyapuri, Viswanathan, Derby, DE24 8BJ (GB); Mohamed Halick, Mohamed Sathik, Derby, DE24 8BJ (GB); Kumar, Logesh, Derby, DE24 8BJ (GB)
(74) Representative: Rolls-Royce plc

(57) **Abstract**

The disclosure relates to monitoring of power electronics modules for multiphase electrical machines, in particular to determine the presence or absence of a fault. Example embodiments include a method of monitoring a system (100) comprising first and second multiphase electrical machines (101₁, 101₂) driven by respective first and second inverters (102₁, 102₂) from respective first and second DC electrical supplies (103₁, 103₂), the method comprising measuring DC link currents and voltages (Idc1, Idc2, Vdc1, Vdc2), stator currents and voltages (Ia1, Ib1, Ic1, Ia2, Ib2, Ic2, Va1, Vb1, Vc1, Va2, Vb2, Vb3), calculating on-state voltage, on-state resistance and turn-off delay for the inverters (102₁, 102₂) and an equivalent series resistance of the inverters (102₁, 102₂), calculating ratios of the calculated values and determining the presence or absence of a fault in the inverters (102₁, 102₂) based on a combination of two or more of the ratios.

## Description

### TECHNICAL FIELD

The disclosure relates to monitoring a system comprising multiphase electrical machines driven by power electronics modules from DC electrical supplies, in particular to determine the presence or absence of a fault in one of the power electronics modules.

### BACKGROUND

Over recent years, many countries have committed to cut carbon emissions in the coming decades due to environmental concerns. International aviation is included in some of these targets. The electrification of aviation is a potential solution for reducing emissions, enabling the way towards more sustainable aviation. Advantages of electrification can include higher efficiency, lower maintenance requirements, fuel savings and extended control. In so-called 'more electric' aircraft, mechanical, pneumatic and hydraulic subsystems of conventional aircrafts are over time being replaced with electrical counterparts. There is also a growing trend towards all-electric propulsion for small commuter aircraft and hybrid propulsion for larger aircraft.

Urban air mobility (UAM) applications such as air taxis and electric take-off and landing (eVTOL) aircraft may use high-power density permanent magnet electrical machines for power and propulsion. Multiphase electrical machines, typically multiple-three phase electrical machines, can play a key role in these applications for fault tolerant operation. The winding insulation in such machines, which is subjected to high electrical and thermal stresses, may degrade gradually, leading to turn-to-turn short circuit (TTSC) or inter-turn short circuit (ITSC) in the incipient stage. This causes the flow of high short circuit loop currents, which creates local hot-spots and leads to further insulation degradation of the neighboring windings. Turn-to-turn short circuits can lead to winding degradation. When undetected in the early stage, this can lead to catastrophic phase-to-phase short circuits and phase-to-ground short circuits. Hence, there is a need to develop suitable and accurate methods for detecting such kinds of winding failures before they lead to winding degradation.

Power electronics converters are key components in the power and propulsion systems of UAM and eVTOL aircraft. A power electronics converter comprises components including power devices, capacitors, PCBs, and a cooling system. The power devices and capacitors tend to be weak links in any power converter system. Failures in such components can be mainly due to environmental and electrical stresses, which cause periodic wear that may eventually lead to component failures. These failures can be prevented by employing a suitable condition monitoring system to identify and predict component degradation to estimate the remaining useful life.

It is estimated that, in failures of power electronic converters, the capacitors and the power modules can contribute to around 50% of total failures. The failure of a power converter can lead to failure of an entire system or at least severe performance degradation that can make the system unusable. Despite extensive efforts by manufacturers to improve the reliability of power electronic components such as power modules, capacitors and implementation of cautious and conservative design methodologies, power module and capacitor failures can still occur due to wear caused by long term effects of electrical and environmental stress factors. These failures are accelerated in demanding applications such as those in aerospace and defence sectors and can lead to the shutdown of a whole electrical system. Therefore, condition or health monitoring systems capable of tracking the current health status of a power converter and, if necessary, performing failure prognosis is important for critical applications.

Current proposed solutions for condition monitoring of power converters tend to be aimed at identifying individual component failures rather than to provide a solution for an overall power converter.

### SUMMARY

According to a first aspect there is provided a method of monitoring a system comprising first and second multiphase electrical machines driven by respective first and second inverters from respective first and second DC electrical supplies, the method comprising:
i) measuring first and second DC link currents and voltages from the respective first and second DC supplies to the respective first and second inverters;
ii) measuring stator currents and voltages for each phase of each of the first and second electrical machines;
iii) calculating an on-state voltage, an on-state resistance and a turn-off delay for the first and second inverters from the stator currents and voltages;
iv) calculating an equivalent series resistance of DC link capacitors of each of the first and second inverters from the DC link currents and voltages;
v) calculating a first ratio of the turn off delay for the first inverter relative to the turn off delay for the second inverter;
vi) calculating a second ratio of the on-state resistance for the first inverter relative to the on-state resistance for the second inverter;
vii) calculating a third ratio of the on-state voltage for the first inverter relative to the on-state voltage for the second inverter;
viii) calculating a fourth ratio of the equivalent series resistance for the first inverter relative to the equivalent series resistance for the second inverter;
viii) determining the presence or absence of a fault in the first or second inverters based on a combination of two or more of the first, second, third and fourth ratios.

Step viii) may comprise determining a fault in one of the first and second inverters if the first ratio is outside of a first predetermined range between first and second threshold values and the second and third ratios are outside of a second predetermined range between third and fourth threshold values.

The method may comprise determining a fault in a switching module of the first inverter if the second and third ratios are above the third threshold value.

The method may comprise determining a fault in a switching module of the second inverter if the second and third ratios are below the fourth threshold value.

The method may comprise determining the absence of a fault in switching modules of the first and second inverters if the second and third ratios are within the second predetermined range.

Step viii) may comprise determining a fault in a DC link capacitor in one of the first and second inverters if the first ratio is within the first predetermined range and the fourth ratio is outside of the first predetermined range.

The method may comprise determining a fault in a DC link capacitor in the first inverter if the fourth ratio is above the first threshold.

The method may comprise determining a fault in a DC link capacitor in the second inverter if the fourth ratio is below the second threshold.

The method may comprise determining the absence of a fault in the DC link capacitors of the first and second inverters if the fourth ratio is within the first predetermined range.

The first and second predetermined ranges may be within 1 to 5% of 1.

According to a second aspect there is provided a power electronics system comprising:
first and second electrical machines each comprising a plurality of stator phases;
first and second inverters configured to receive a respective first and second DC link current from respective first and second DC supplies and provide AC currents to the plurality of stator phases of the respective first and second electrical machines; and
a condition monitoring unit configured to:
   i) measure first and second DC link currents and voltages from the respective first and second DC supplies to the respective first and second inverters;
   ii) measure stator currents and voltages for each phase of each of the first and second electrical machines;
   iii) calculate an on-state voltage, an on-state resistance and a turn-off delay for the first and second inverters from the stator currents and voltages;
   iv) calculate an equivalent series resistance of DC link capacitors of each of the first and second inverters from the DC link currents and voltages;
   v) calculate a first ratio of the turn off delay for the first inverter relative to the turn off delay for the second inverter;
   vi) calculate a second ratio of the on-state resistance for the first inverter relative to the on-state resistance for the second inverter;
   vii) calculate a third ratio of the on-state voltage for the first inverter relative to the on-state voltage for the second inverter;
   viii) calculate a fourth ratio of the equivalent series resistance for the first inverter relative to the equivalent series resistance for the second inverter;
   viii) determine the presence or absence of a fault in the first or second inverters based on a combination of two or more of the first, second, third and fourth ratios.

The condition monitoring unit may be configured to determine a fault in one of the first and second inverters if the first ratio is outside of a first predetermined range between first and second threshold values and the second and third ratios are outside of a second predetermined range between third and fourth threshold values.

The condition monitoring unit may be configured to determine a fault in a switching module of the first inverter if the second and third ratios are above the third threshold value.

The condition monitoring unit may be configured to determine a fault in a switching module of the second inverter if the second and third ratios are below the fourth threshold value.

The condition monitoring unit may be configured to determine the absence of a fault in switching modules of the first and second inverters if the second and third ratios are within the second predetermined range.

The condition monitoring unit may be configured to determine a fault in a DC link capacitor in one of the first and second inverters if the first ratio is within the first predetermined range and the fourth ratio is outside of the first predetermined range.

The condition monitoring unit may be configured to determine a fault in a DC link capacitor in the first inverter if the fourth ratio is above the first threshold.

The condition monitoring unit may be configured to determine a fault in a DC link capacitor in the second inverter if the fourth ratio is below the second threshold.

The condition monitoring unit may be configured to determine the absence of a fault in the DC link capacitors of the first and second inverters if the fourth ratio is within the first predetermined range.

The first and second predetermined ranges may be within 1 to 5% of 1.

According to a third aspect there is provided a computer program comprising instructions that, when executed, cause a computer to perform the method according to the first aspect. The computer program may be stored on a non-transitory computer-readable medium.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

### BRIEF DESCRIPTION OF THE DRAWINGS

Embodiments will now be described by way of example only with reference to the accompanying drawings, which are purely schematic and not to scale, and in which:
**Figure 1** is a schematic diagram of an example multi-lane system with power electronics module monitoring; and
**Figure 2** is a flow diagram of an example method of determining the presence or absence of a fault in a power electronics module of a multi-lane system.

### DETAILED DESCRIPTION

The method and system described herein provides a monitoring solution for multi-lane power converters that include power devices, i.e. high power semiconductor switching elements, and capacitors. Simple and accurate fault detection techniques are described that enable measurement and extraction of fault signatures to enable detection of a fault in one of the power electronics modules. A requirement is that there are at least two multi-phase machines and that the multi-phase machines are electrically and magnetically isolated. There are various benefits of the proposed methods for fault detection, including: i) additional sensors not being required; ii) historical data not being required; iii) fixed threshold parameters not being required; iv) the methods being applicable to all winding types, provided they are electrically and magnetically isolated; v) the proposed methods working for multiple-three phase electrical machines; and vi) the proposed methods being computationally simple.

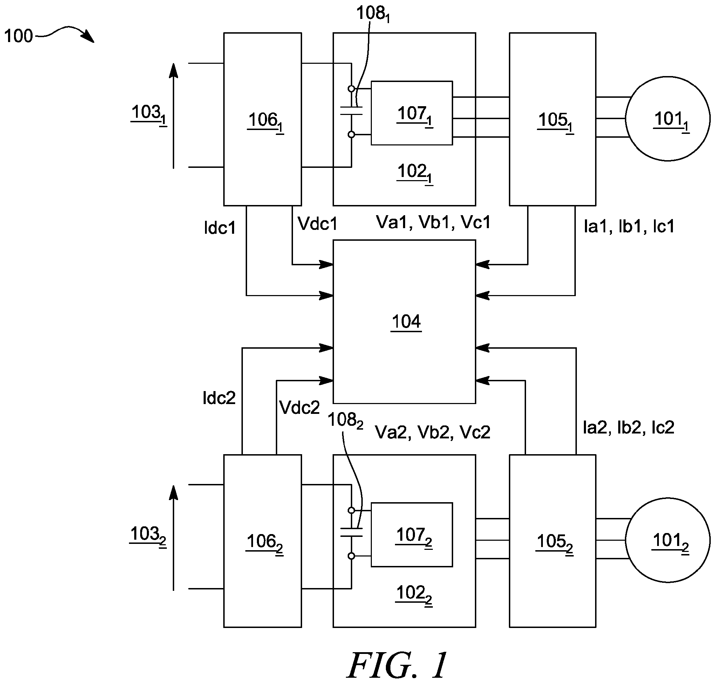

Figure 1 illustrates an example system 100 comprising first and second electrical machines 101₁, 101₂. The first and second electrical machines 101₁, 101₂ may be separate machines or may be electrical machines with a common stator. Each of the electrical machines 101₁, 101₂ comprises a plurality of phases, in this example three phases. The electrical machines 101₁, 101₂ are magnetically and electrically isolated from each other, which allows the machines to be monitored in comparison to each other. Each of the electrical machines 101₁, 101₂ may operate as a motor or as a generator.

When operating as a motor, each of the three phase windings in the electrical machines 101₁, 101₂ is driven by a respective power electronics module, or inverter, 102₁, 102₂, each inverter being powered by a respective DC power supply 103₁, 103₂, which may be referred to as a lane in a multi-lane system. In a multiphase machine, the set of three phase windings can be phase shifted electrically by zero degrees or -180 degrees. The electrical machines 101₁, 101₂ are nominally identical, i.e. have the same characteristics, and are driven by nominally identical respective inverters 102₁, 102₂.

Each of the first and second inverters 102₁, 102₂ comprises a switching module 107₁, 107₂ and a DC link capacitor 108₁, 108₂. Faults may develop during use in either of these components, which the method described below can be used to detect and diagnose.

A health or condition monitoring unit 104 receives AC stator current measurements signals Ia1, Ib1, Ic1, Ia2, Ib2, Ic2 and AC stator voltage measurement signals Va1, Vb1, Vc1, Va2, Vb2, Vc2 for each stator phase from first and second stator sensing modules 105₁, 105₂ that are connected to sense voltages and current of the stator windings of the respective first and second electrical machines 101₁, 101₂. DC link current and voltage measurement signals Idc1, Idc2, Vdc1, Vdc2 are received from first and second DC link sensor modules 106₁, 106₂ that are connected to sense voltages across the respective first and second DC power supplies 103₁, 103₂ and current flowing from the respective first and second DC power supplies 103₁, 103₂. to the respective power electronics modules 102₁, 102₂. The DC link voltages, DC link currents, three phase voltages and three phase currents of the two inverters 102₁ 102₂ are used by the condition monitoring unit 104 to monitor the health or condition of the inverters 102₁, 102₂.

Currents through each of the stator phases may be measured, although may need to be measured in only some of the phases. In a three phase electrical machine, for example, the current in only two of the phases needs to be measured, since the current in the third phase can be inferred from the other two currents. For the three currents Ia1, Ib1, Ic1 flowing through the windings of the first machine 101₁, the current through phase c can be extracted using the relationship Ia1+Ib1+Ic1=0, i.e. Ic1=-Ia1-Ib1.

Based on these measurements of current supplied to the inverters 102₁, 102₂ and through each of the stator phases in each of the electrical machines 101₁, 101₂, the condition monitoring unit 104 performs calculations and determines whether a fault may be present in the first or second inverter 102₁, 102₂.

The condition monitoring unit 104 may be a separate component to the inverters 102₁, 102₂ or, in some arrangements, may be provided as part of one or other of the inverters 102₁, 102₂. The condition monitoring unit 104 may be implemented using general purpose computer hardware, i.e. with an input/output module for receiving measurement signals from current and voltage sensors and for providing outputs indicating the condition of the system 100, a processing module for carrying out calculations and a memory module for storing data. The method of monitoring the system 100 may therefore be described as a computer-implemented method and may be embodied by instructions for causing a computer to perform the method.

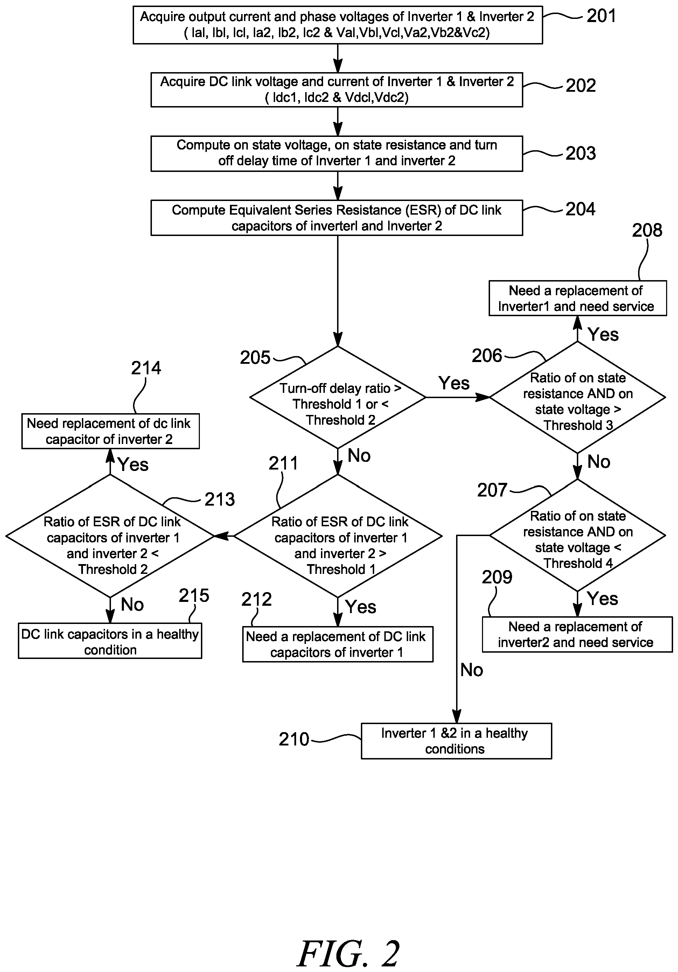

Figure 2 illustrates a fault diagnosis algorithm performed by the condition monitoring unit 104 in the form of a flow diagram. The algorithm uses various available sensor parameters including stator currents and voltages and DC-link currents and voltages from each lane, as defined above, to carry out a process of fault diagnosis. The current and voltage sensors required for this do not need to be new sensors but can be sensors that are primarily installed to control the speed and torque of each of the electrical machines 101₁, 101₂.

The method uses: voltages of each output phase of the first and second inverters 102₁, 102₂, termed Va1, Vb1, Vc1, Va2, Vb2, Vc2; stator currents provided by the first and second inverters 102₁, 102₂, termed Ia1, Ib1, Ic1, Ia2, Ib2, Ic2; DC link voltages across the first and second inverters 102₁, 102₂, termed Vdc1, Vdc2; and DC currents supplied to the first and second inverters 102₁, 102₂, termed Idc1, Idc2. The voltages of each phase may be measured relative to a ground or common voltage reference, for example the negative or ground DC level at the inverter input. From these voltage and current measurements, the on-state voltage, on-state resistance, and turn-off delay time of the power switches in both inverters 102₁, 102₂ can be estimated.

The on-state resistance for each phase of each inverter can be calculated by dividing the measured voltage by the measured current when the respective inverter switch is conducting. For, example, for phase a of the first inverter 107₁, the on-state resistance is calculated from Va1/la1 when the inverter switch for phase a is conducting.

The turn-off delay time for each phase of each inverter can be estimated by measuring the time taken for the voltage across each inverter switch to fall from high to low, for example from 90% of the input voltage to 10% of the input voltage. This turn-off delay time should normally be within defined bounds and nominally identical for all inverter switches.

The turn-off delay and on-state resistance for each inverter may be a combination of measurements taken for each of the inverter switches in each of the first and second inverters 107₁, 107₂, for example a sum or average of measurements taken from each of the inverter switches.

The equivalent series resistance and capacitance can be estimated from the DC link voltage and current measurements. The equivalent series resistance of each inverter is the real part of the DC voltage divided by the DC current, i.e. Real [V_{DC}/I_{DC}], while the capacitance can be determined by the imaginary part, i.e. Img [V_{DC}/I_{DC}].

Ratios are then calculated for all the extracted or estimated parameters for the first inverter 102₁ relative to the second inverter 102₂. During normal operation, these ratios should all be close to 1, indicating that the first and second inverters are operating nominally. A deviation away from 1 will tend to indicate that one of the inverters has a fault, which may be either a DC link capacitor fault or a fault in a semiconductor switching component. The direction of deviation will indicate which of the two electrical machines has a fault and the different ratios will enable detection of the type of fault.

At step 205, a first ratio is calculated of the turn-off delay time for the first inverter relative to the turn-off delay time for the second inverter. If this first ratio is outside of a first predetermined range defined by first and second thresholds, i.e. if the first ratio is greater than the first threshold or less than the second threshold, the method proceeds to step 206. A second predetermined range is defined by third and fourth thresholds, which are used to establish whether the first or second invertors are faulty or healthy. At step 206 a third ratio of the on-state resistance of the first inverter relative to the on-state resistance of the second inverter and a fourth ratio between the on-state voltage of the first inverter relative to the on-state voltage of the second inverter are compared to the third threshold. If the third and fourth ratios are greater than the third threshold, this determines that the first inverter is faulty and needs replacement or servicing (step 208). If, at step 206, the third and fourth ratios are not greater than the third threshold, at step 207 the third and fourth ratios are compared to the fourth threshold. If, at step 207, the third and fourth ratios are less than the fourth threshold, this determines that the second inverter is faulty and needs replacement or servicing (step 209). Otherwise, i.e. if the third and fourth ratios are determined in steps 206 and 207 to be within the second predetermined range, the first and second inverters are determined to be in a healthy condition (step 210).

Returning to step 205, if the first ratio is not outside of the first predetermined range, i.e. between the first and second thresholds, at step 211 a fourth ratio of the equivalent series resistance of the DC link capacitor of the first inverter to the equivalent series resistance of the DC link capacitor of the second inverter is compared to the first predetermined range. If, at step 211, the fourth ratio is greater than the first threshold, this indicates that the DC link capacitor of the first inverter is faulty and needs replacement (step 212). If, at step 211, the fourth ratio is not greater than the first threshold, at step 213 the fourth ratio is compared to the second threshold. If, at step 213, the fourth ratio is less than the fourth threshold, this indicates that the DC link capacitor of the second inverter is faulty and needs replacement (step 214). Otherwise, i.e. if the fourth ratio is determined in steps 212 and 213 to be within the first predetermined range, the DC link capacitors of the first and second inverters are determined to he healthy (step 215).

Each of the end steps 208, 209, 210, 214, 215 may result in an output provided by the condition monitoring unit 104, indicating whether or not there is a fault and, if so, what type of fault and in which inverter the fault is determined to be. A fault indication may be provided as an alert to another unit connected to the condition monitoring unit so that a user can take necessary action.

If the end steps 210 or 215 are reached, the process may repeat starting from step 201. The process may be repeated continually or may be run at defined intervals or at certain points of operation, for example during a startup or shutdown operation.

Each of the first and second predetermined ranges, defined by the first, second, third and fourth threshold values, may for example be between around 0.99 and 1.01, between around 0.98 and 1.02, around between 0.95 and 1.95, i.e. within around 1 to 5% or 1. The ranges may be selected based on variation in the ratios during normal operation, for example due to noise and normal variation between the first and second inverters to reduce the possibility of a fault being incorrectly identified.

At each of the decisions steps 205, 206, 207, 211, 213, the decision may be taken based on a ratio remaining stable for longer than a predetermine period, which may for example be longer than 5 seconds, 10 seconds or 30 seconds. This reduces the possibility of a fault being incorrectly detected due to temporary fluctuations.

## Claims

1. A method of monitoring a system (100) comprising first and second multiphase electrical machines (101₁, 101₂) driven by respective first and second inverters (102₁, 102₂) from respective first and second DC electrical supplies (103₁, 103₂), the method comprising:
i) measuring first and second DC link currents and voltages (Idc1, Idc2, Vdc1, Vdc2) from the respective first and second DC supplies (103₁, 103₂) to the respective first and second inverters (102₁, 102₂);
ii) measuring stator currents and voltages (Ia1, Ib1, Ic1, Ia2, Ib2, Ic2, Va1, Vb1, Vc1, Va2, Vb2, Vb3) for each phase of each of the first and second electrical machines (101₁, 101₂);
iii) calculating an on-state voltage, an on-state resistance and a turn-off delay for the first and second inverters (102₁, 102₂) from the stator currents and voltages (Ia1, Ib1, Ic1, Ia2, Ib2, Ic2, Va1, Vb1, Vc1, Va2, Vb2, Vb3);
iv) calculating an equivalent series resistance of DC link capacitors (108₁, 108₂) of each of the first and second inverters (102₁, 102₂) from the DC link currents and voltages (Idc1, Idc2, Vdc1, Vdc2);
v) calculating a first ratio of the turn off delay for the first inverter (102₁) relative to the turn off delay for the second inverter (102₂);
vi) calculating a second ratio of the on-state resistance for the first inverter (102₁) relative to the on-state resistance for the second inverter (102₂);
vii) calculating a third ratio of the on-state voltage for the first inverter (102₁) relative to the on-state voltage for the second inverter (102₂);
viii) calculating a fourth ratio of the equivalent series resistance for the first inverter (102₁) relative to the equivalent series resistance for the second inverter (102₂);
viii) determining the presence or absence of a fault in the first or second inverters (102₁, 102₂) based on a combination of two or more of the first, second, third and fourth ratios.

2. The method of claim 1, wherein step viii) comprises determining a fault in one of the first and second inverters (102₁, 102₂) if the first ratio is outside of a first predetermined range between first and second threshold values and the second and third ratios are outside of a second predetermined range between third and fourth threshold values.

3. The method of claim 2, comprising determining a fault in a switching module (107₁) of the first inverter (102₁) if the second and third ratios are above the third threshold value.

4. The method of claim 2, comprising determining a fault in a switching module (107₂) of the second inverter (102₂) if the second and third ratios are below the fourth threshold value.

5. The method of claim 2, comprising determining the absence of a fault in switching modules (107₁, 107₂) of the first and second inverters (102₁, 102₂) if the second and third ratios are within the second predetermined range.

6. The method of claim 1, wherein step viii) comprises determining a fault in a DC link capacitor (108₁, 108₂) in one of the first and second inverters (102₁, 102₂) if the first ratio is within the first predetermined range and the fourth ratio is outside of the first predetermined range.

7. A power electronics system (100) comprising:
first and second electrical machines (101₁, 101₂) each comprising a plurality of stator phases;
first and second inverters (102₁, 102₂) configured to receive a respective first and second DC link current (Idc1, Idc2) from respective first and second DC supplies (103₁, 103₂) and provide AC currents (la1, Ib1, Ia2, Ib2) to the plurality of stator phases of the respective first and second electrical machines (101₁, 101₂);
a condition monitoring unit (104) configured to:
i) measure first and second DC link currents and voltages (Idc1, Idc2, Vdc1, Vdc2) from the respective first and second DC supplies (103₁, 103₂) to the respective first and second inverters (102₁, 102₂);
ii) measure stator currents and voltages (Ia1, Ib1, Ic1, Ia2, Ib2, Ic2, Va1, Vb1, Vc1, Va2, Vb2, Vb3) for each phase of each of the first and second electrical machines (101₁, 101₂);
iii) calculate an on-state voltage, an on-state resistance and a turn-off delay for the first and second inverters (102₁, 102₂) from the stator currents and voltages (Ia1, Ib1, Ic1, Ia2, Ib2, Ic2, Va1, Vb1, Vc1, Va2, Vb2, Vb3);
iv) calculate an equivalent series resistance of DC link capacitors (108₁, 108₂) of each of the first and second inverters (102₁, 102₂) from the DC link currents and voltages (Idc1, Idc2, Vdc1, Vdc2);
v) calculate a first ratio of the turn off delay for the first inverter (102₁) relative to the turn off delay for the second inverter (102₂);
vi) calculate a second ratio of the on-state resistance for the first inverter (102₁) relative to the on-state resistance for the second inverter (102₂);
vii) calculate a third ratio of the on-state voltage for the first inverter (102₁) relative to the on-state voltage for the second inverter (102₂);
viii) calculate a fourth ratio of the equivalent series resistance for the first inverter (102₁) relative to the equivalent series resistance for the second inverter (102₂);
viii) determine the presence or absence of a fault in the first or second inverters (102₁, 102₂) based on a combination of two or more of the first, second, third and fourth ratios.

8. The power electronics system (100) of claim 7, wherein the condition monitoring unit (104) is configured to determine a fault in one of the first and second inverters (102₁, 102₂) if the first ratio is outside of a first predetermined range between first and second threshold values and the second and third ratios are outside of a second predetermined range between third and fourth threshold values.

9. The power electronics system (100) of claim 8, wherein the condition monitoring unit (104) is configured to determine a fault in a switching module (107₁) of the first inverter (102₁) if the second and third ratios are above the third threshold value.

10. The power electronics system (100) of claim 8, wherein the condition monitoring unit (104) is configured to determine a fault in a switching module (107₂) of the second inverter (102₂) if the second and third ratios are below the fourth threshold value.

11. The power electronics system (100) of claim 8, wherein the condition monitoring unit (104) is configured to determine the absence of a fault in switching modules (107₁, 107₂) of the first and second inverters (102₁, 102₂) if the second and third ratios are within the second predetermined range.

12. The power electronics system (100) of claim 7, wherein the condition monitoring unit (104) is configured to determine a fault in a DC link capacitor (108₁, 108₂) in one of the first and second inverters (102₁, 102₂) if the first ratio is within the first predetermined range and the fourth ratio is outside of the first predetermined range.

13. The power electronics system (100) of claim 12, the condition monitoring unit (104) is configured to determine a fault in a DC link capacitor (108₁) in the first inverter (102₁) if the fourth ratio is above the first threshold.

14. The power electronics system (100) of claim 12, the condition monitoring unit (104) is configured to determine a fault in a DC link capacitor (108₂) in the second inverter (102₂) if the fourth ratio is below the second threshold.

15. The power electronics system (100) of claim 12, the condition monitoring unit (104) is configured to determine the absence of a fault in the DC link capacitors (108₁, 108₂) of the first and second inverters (102₁, 102₂) if the fourth ratio is within the first predetermined range.
